# NEUE EUROPÄISCHE PATENTSCHRIFT

(11) **EP 1 818 505 B2**
(45) Veröffentlichungstag und Bekanntmachung des Hinweises auf die Entscheidung über den Einspruch: **13.12.2017**
(45) Hinweis auf die Patenterteilung: 13.08.2008
(21) Anmeldenummer: 06002582.2
(22) Anmeldetag: 08.02.2006
(51) Int. Cl.: F01D 5/28, C23C 30/00, G01N 1/00

(54) **Verfahren zum Herstellen einer Beschichtungsprobe**
Process to produce a coating sample
Procédé de fabrication d'un revêtement d'échantillons

(43) Veröffentlichungstag der Anmeldung: 15.08.2007
(73) Patentinhaber: Siemens Aktiengesellschaft, 80333 München (DE)
(72) Erfinder: Berndt, Thomas, 12524 Berlin (DE); Ladru, Francis-Jurjen, Dr., 14050 Berlin (DE); Mensing, Marcus, 13465 Berlin (DE); Reymann, Helge, 14167 Berlin (DE); Wanigasinghe, Mahinda, 10940 Middleton, NY (US)

(56) Entgegenhaltungen:
- EP-A- 1 072 692
- EP-A- 1 464 723
- DE-A1- 19 754 547
- US-A- 5 329 810
- PATENT ABSTRACTS OF JAPAN Bd. 2000, Nr. 26, 1. Juli 2002 (2002-07-01) & JP 2001 264227 A (TOSHIBA CORP), 26. September 2001 (2001-09-26)
- PATENT ABSTRACTS OF JAPAN Bd. 2003, Nr. 12, 5. Dezember 2003 (2003-12-05) & JP 2005 146291 A (TOSHIBA CORP), 9. Juni 2005 (2005-06-09)

## Beschreibung

Die vorliegende Erfindung betrifft ein Verfahren zum Herstellen einer Beschichtungsprobe zur Untersuchung von Beschichtungsparametern einer auf eine bestimmte Bauteilsorte aufzubringenden Beschichtung.

Beschichtete Bauteile spielen in der heutigen Technik eine große Rolle, wenn Eigenschaften von Bauteiloberflächen beeinflusst werden sollen. Beispiele für durch geeignete Beschichtungen zu beeinflussende Eigenschaften von Bauteiloberflächen sind die Reibung, die Oxidations- und/oder Korrosionsbeständigkeit oder die Wärmeleitfähigkeit des Bauteils im Oberflächenbereich. So werden beispielsweise thermisch hochbelastete Gasturbinenbauteile wie etwa die Turbinenschaufeln häufig mit Beschichtungen versehen, um ihre Korrosions- und/oder Oxidationsbeständigkeit zu erhöhen und die Wärmeleitfähigkeit der Oberfläche zu verringern. Bei den im Betrieb einer Gasturbine herrschenden Umgebungsbedingungen ist eine einwandfreie Beschichtung von großer Bedeutung. Fehlerhafte Beschichtungen können zu einem zu raschen Verschleiß der Bauteile führen, was ein Überarbeiten oder gar den Austausch des verschlissenen Bauteils erforderlich macht und daher lange Standzeiten der Anlage verursachen kann.

Es besteht daher der Bedarf, die Parameter einer Beschichtung im Rahmen einer Beschichtungsprobe zu ermitteln, um Aussagen über die Zuverlässigkeit des Beschichtungsprozesses und die damit erzeugten Beschichtungen zu erhalten. Üblicherweise werden hierzu Bauteile der zu beschichtenden Bauteilsorte als Probe genommen wie aus der JP 2001 264 227 bekannt. Diese werden beschichtet und anschließend einer zerstörenden Untersuchung unterzogen, um beispielsweise den Querschnitt der Beschichtung untersuchen zu können. Das als Beschichtungsprobe verwendete Bauteil ist hinterher nicht weiter zu gebrauchen. Insbesondere bei Bauteilen, welche in der Herstellung aufwendig und teuer sind, ist es deshalb wünschenswert, möglichst wenige der Bauteile einer zerstörenden Untersuchung unterziehen zu müssen.

Die EP 1 072 692 A2 offenbart ein Verfahren, bei dem eine Turbinenschaufel zerteilt und mit Materialscheiben versehen einem Beschichtungsprozess unterzogen wird.

US 5,329,810 betrifft ein Verfahren, bei dem Klebestreifen auf einem zu lackierenden Objekt aufgebracht und nach einer Lackierung als Proben verwendet werden.

Aufgabe der vorliegenden Erfindung ist daher, ein Verfahren zum Herstellen einer Beschichtungsprobe zur Verfügung zu stellen, mit welchem sich die Zahl der zum Herstellen von Beschichtungsproben benötigten Bauteile verringern lässt.

Die genannte Aufgabe wird durch ein Verfahren zum Herstellen einer Beschichtungsprobe nach Anspruch 1 gelöst. Die abhängigen Ansprüche enthalten vorteilhafte Ausgestaltungen des Verfahrens.

Im erfindungsgemäßen Verfahren zum Herstellen einer Beschichtungsprobe zur Untersuchung von Beschichtungsparametern einer auf einer bestimmte Bauteilsorte aufzubringenden Beschichtung erfolgt ein Aufbringen wenigstens eines Materialstreifens auf wenigstens eine bestimmte Oberflächenstelle eines Bauteils der zu beschichtenden Bauteilsorte. Das Bauteil, auf welches der wenigstens eine Materialstreifen aufgebracht wird, dient dabei als Trägerbauteil. Das Material des Materialstreifens ist derart gewählt, dass der Beschichtungsvorgang auf den Materialstreifen dem Beschichtungsvorgang auf das Material, aus dem das Bauteil hergestellt ist, zumindest in Hinblick auf die zu untersuchenden Beschichtungsparameter entspricht. Als Materialstreifen sollen ungeachtet ihrer Form insbesondere solche Körper angesehen werden, deren laterale Abmessungen ihre Dicke weit übersteigen. Nach dem Aufbringen des wenigstens einen Materialstreifens erfolgt ein Beschichten des Bauteils. Danach wird der Materialstreifen zu Verwendung als Beschichtungsprobe vom Bauteil entfernt.

Im erfindungsgemäßen Verfahren wird also nicht das Bauteil selbst als Beschichtungsprobe verwendet. Stattdessen dient es lediglich als Träger für den Materialstreifen, der die eigentliche Beschichtungsprobe bildet. Die Untersuchung der Beschichtung findet dann am losgelösten Materialstreifen statt. Eine Zerstörung des Bauteils erfolgt hierbei nicht. Es kann daher erneut als Träger für einen Materialstreifen als Beschichtungsprobe Verwendung finden. Auf diese Weise lässt sich der Verbrauch an Bauteilen als Beschichtungsprobe stark reduzieren.

Besonders Vorteilhaft ist es, wenn Materialstreifen auf eine Mehrzahl von Oberflächenstellen des Trägerbauteils aufgebracht werden. Auf diese Weise lassen sich Beschichtungseigenschaften einer Vielzahl von Oberflächenbereichen des Trägerbauteils untersuchen.

Das Wiederverwenden des Trägerbauteils wird dadurch vereinfacht, dass das Fixieren das Materialstreifens auf der Oberfläche des Trägerbauteils mittels einer leicht zu lösenden Verbindung erfolgt. Diese Fixierung wird mittels eines Punktschweißverfahrens hergestellt also einem Schweißverfahren, in dem nicht der gesamte Materialstreifen mit dem Bauteil verschweißt wird, sondern das Verschweißen lediglich an einigen, im Verhältnis zu seiner Ausdehnung kleinen Stellen das Materialstreifens erfolgt.

Nachdem der Materialstreifen als Beschichtungsprobe von der Oberfläche des Trägerbauteils entfernt worden ist, wird vorzugsweise die Beschichtung von der Oberfläche des Trägerbauteils, also von denjenigen Oberflächenbereichen, welche von dem wenigstens einen Materialstreifen nicht bedeckt waren, entfernt, um es für eine erneute Verwendung als Trägerbauteil vorzubereiten.

Wie weiter oben beschrieben, ist das Material des Materialstreifens derart gewählt, dass der Beschichtungsvorgang auf dem Materialstreifen dem des Materials, aus dem das Bauteil hergestellt ist, zumindest im Hinblick auf die zu untersuchenden Beschichtungsparameter entspricht. Wenn beispielsweise die Bauteile der Bauteilsorte aus einer Legierung mit einem bestimmten Basismaterial als Hauptbestandteil hergestellt sind, kann das Material des wenigstens einen Materialstreifens ebenfalls dieses Basismaterial als Hauptbestandteil aufweisen. Insbesondere bei Lauf- oder Leitschaufeln von Gasturbinenanlagen kommen als Basismaterialien Eisen (Fe), Nickel (Ni)oder Kobalt (Co) in Frage.

Weitere Merkmale, Eigenschaften und Vorteile der vorliegenden Erfindung ergeben sich aus der nachfolgenden Beschreibung von Ausführungsbeispielen und Bezugnahme auf die beiliegenden Figuren.
- Figur 1: zeigt beispielhaft eine Gasturbinenanlage in einem Längsteilschnitt.
- Figur 2: zeigt in perspektivischer Ansicht eine Laufschaufel oder Leitschaufel eine Strömungsmaschine.
- Figur 3: zeigt eine Brennkammer einer Gasturbinenanlage.
- Figur 4: zeigt eine Turbinenschaufel als Trägerbauteil für Materialstreifen.

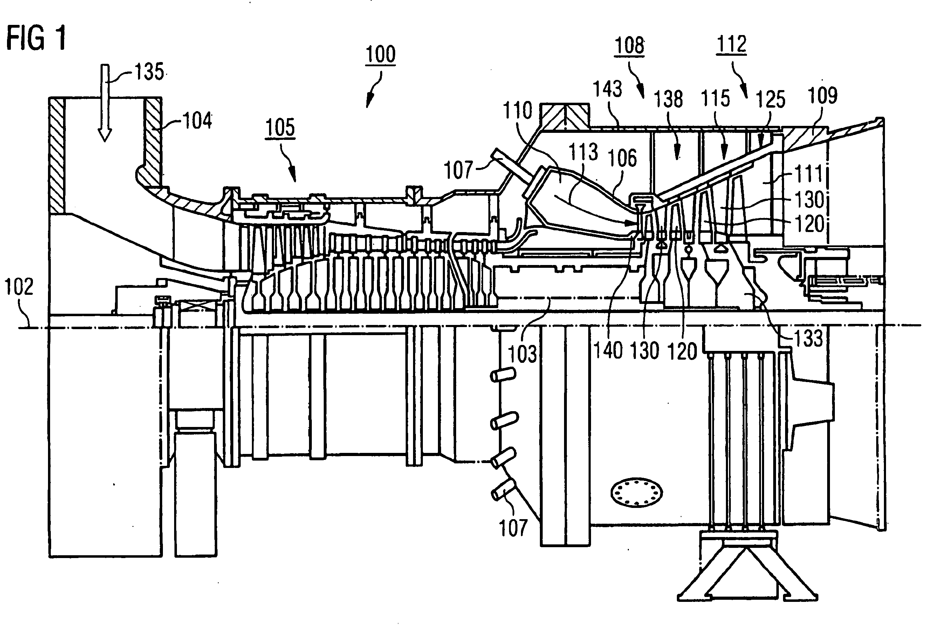

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1 204 776 B1, EP 1 306 454, EP 1 319 729 A1; WO 99/67435 oder WO 00/44949 bekannt; diese Schriften sind Teil der Offenbarung.

Ebenso können die Schaufeln 120, 130 Beschichtungen gegen Korrosion (MCrAIX; M istzumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAIX kann noch eine Wärmedämmschicht vorhanden sein, und besteht beispielsweise aus ZrO₂, Y₂O₃-ZrO₂ d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

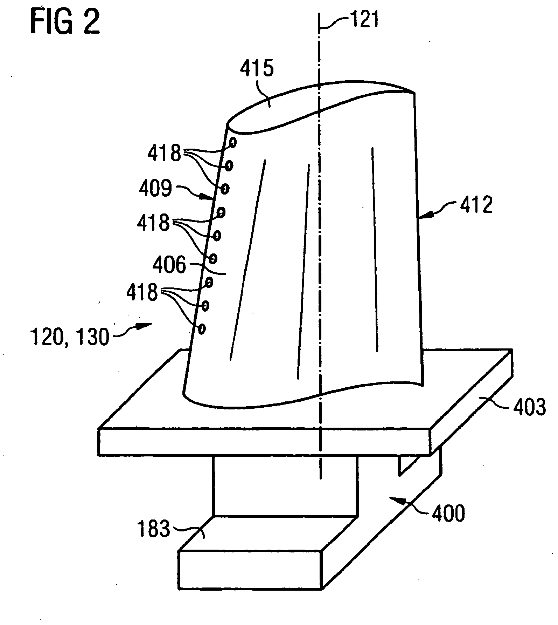

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1 204 776 B1, EP 1 306 454, EP 1 319 729 A1, WO 99/67435 oder WO 00/44949 bekannt; diese Schriften sind Teil der Offenbarung. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt; diese Schriften sind Teil der Offenbarung.

Ebenso können die Schaufeln 120, 130 Beschichtungen gegen Korrosion oder Oxidation (MCrAIX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die Teil dieser Offenbarung sein sollen.

Auf der MCrAIX kann noch eine Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

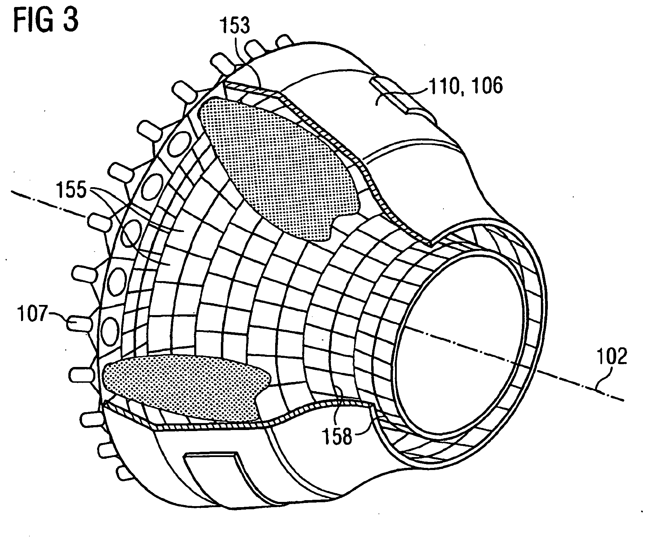

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrAlX und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

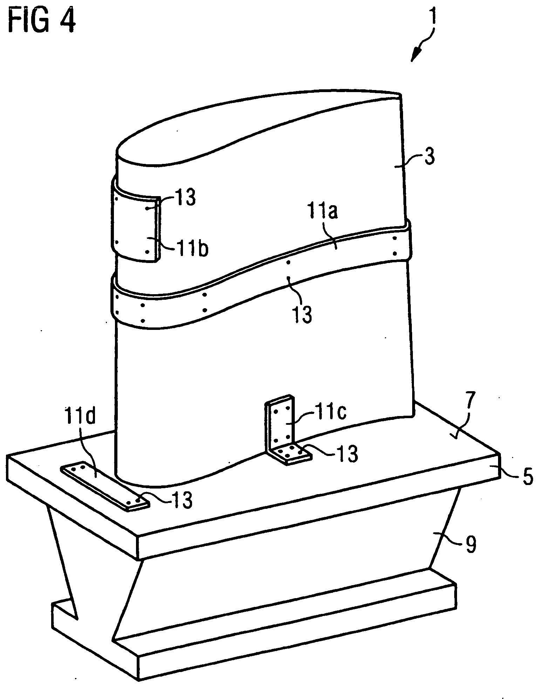

Das erfindungsgemäße Verfahren zum Herstellen einer Beschichtungsprobe wird nachfolgend mit Bezug auf Figur 4 anhand des Herstellens einer Beschichtungsprobe für eine Gasturbinenschaufel beschrieben. Die Gasturbinenschaufel 1 repräsentiert eine Turbinenschaufelsorte, die mit einer Beschichtung, beispielsweise einer MCrAlX-Beschichtung und/oder einer keramischen Wärmedämmbeschichtung, auch TBC - Thermal Barrier Coating - genannt versehen werden soll. Die Beschichtung ist auf das Schaufelblatt 3 und die dem Schaufelblatt 3 zugewandte Oberfläche 7 der Schaufelplattform 5 aufzubringen. Der Schaufelfuß 9 und die übrigen Oberflächenbereiche der Schaufelplattform 5 sollen hingegen nicht beschichtet werden.

Die Turbinenschaufel 1 ist aus einer hochwarmfesten Superlegierung auf Nickel- oder Kobaltbasis hergestellt.

Die in Figur 4 dargestellte Turbinenschaufel 1 dient als ein Trägerbauteil für eine Anzahl von Materialstreifen 11a bis 11d, die auf verschiedene Oberflächenbereiche von Schaufelblatt 3 und Schaufelplattform 5 aufgebracht werden. Es sei an dieser Stelle angemerkt, dass die in Figur 4 dargestellten Oberflächenbereiche lediglich der Veranschaulichung dienen. Die tatsächlich verwendeten Oberflächenbereiche können u.a. davon abhängen, welche Eigenschaften der Beschichtung untersucht werden sollen und welche Geometrie die Turbinenschaufel aufweist.

Die Materialstreifen 11a bis 11d sind aus einem dem Basismaterial der Turbinenschaufel in seinen Beschichtungseigenschaften ähnlichen Material hergestellt. Wenn das Basismaterial der hochwarmfesten Superlegierung etwa Nickel ist, so können die Materialstreifen beispielsweise aus einer Legierung auf Nickelbasis oder aus Nickel hergestellt. Es ist jedoch grundsätzlich auch möglich, die Materialstreifen aus anderen Metallen oder Legierungen herzustellen, solange die gewählten Metalle beziehungsweise Legierungen im Hinblick auf die zu untersuchenden Beschichtungsparameter dieselben oder sehr ähnliche Beschichtungseigenschaften wie die Superlegierung aufweisen.

Die Materialstreifen 11a bis 11d werden mittels eines Punktschweißprozesses an Schaufelblatt 3 und Schaufelplattform 5 befestigt. Dies ermöglicht das leichte Ablösen der Materialstreifen 11a bis 11d, nachdem der Beschichtungsvorgang durchgeführt worden ist. Mögliche Stellen zum Fixieren der Materialstreifen 11a bis 11d am Schaufelblatt beziehungsweise an der Schaufelplattform 5 sind in Figur 4 schematisch durch Punkte 13 angedeutet.

Nachdem alle Materialstreifen 11a bis 11d an den vorgesehenen Stellen von Schaufelblatt 3 und Schaufelplattform 5 befestigt sind, wird die Turbinenschaufel 1 dem Beschichtungsprozess, wie er für diese Turbinenschaufelsorte durchgeführt wird, unterzogen. Nach Abschluss des Beschichtungsprozesses werden die Materialstreifen 11a bis 11d entfernt und können als Beschichtungsprobe eine Auswertung unterzogen werden. Die Turbinenschaufel 1, die lediglich als Trägerbauteil für die Materialstreifen 11a bis 11d während des Beschichtungsprozesses gedient hat, wird wieder vollständig entschichtet und steht dann erneut als Trägerbauteil für Materialstreifen zur Verfügung.

Sofern sich die Materialstreifen nicht bereits anhand ihrer Form und Größe voneinander unterscheiden lassen, so können diese mit einer Markierung versehen sein, die ihre Position auf dem Schaufelblatt 3 beziehungsweise der Schaufelplattform 5 während des Beschichtungsprozesses angibt. Auf diese Weise kann sichergestellt werden, dass auch nach dem Entfernen der Materialstreifen 11a bis 11d von der Turbinenschaufel 1 ihre Position während des Beschichtungsprozesses festgestellt werden kann.

Durch geeignete Auswahl der Oberflächenbereiche, an denen die Materialstreifen 11a bis 11d für das Durchführen des Beschichtungsprozesses angebracht werden, können insbesondere auch über die Turbinenschaufel 1 variierende Parameter der Beschichtung untersucht werden.

Es sei an dieser Stelle noch angemerkt, dass die Dicke der Materialstreifen 11a bis 11d in Figur 4 übertrieben dargestellt ist. Die Dicke ist insbesondere so dünn gewählt, dass die Form der Materialstreifen flexibel an die Form des Oberflächenbereiches, auf dem sie aufgebracht werden, angepasst werden kann. Die Dicke kann insbesondere weniger als 1 mm betragen.

## Patentansprüche

1. Verfahren zum Herstellen einer Beschichtungsprobe zur Untersuchung von Beschichtungsparametern einer auf eine bestimmte Bauteilsorte aufzubringenden Beschichtung mit den Schritten:
- Aufbringen wenigstens eines Materialstreifens (11a bis 11d) auf wenigstens eine bestimmte Oberflächenstelle eines Bauteils (1) der zu beschichtenden Bauteilsorte, welches ein Trägerbauteil bildet, wobei das Material des Materialstreifens (11a bis 11d) derart gewählt ist dass der Beschichtungsvorgang auf dem Materialstreifen (11a bis 11d) dem des Materials, aus dem das Bauteil (1) hergestellt ist, zumindest im Hinblick auf die zu untersuchenden Beschichtungsparameter entspricht;
- Beschichten des Trägerbauteils (1) mit dem wenigstens einen darauf aufgebrachten Materialstreifen;
- Entfernen des Materialstreifens (11a bis 11d) zur Verwendung als Beschichtungsprobe,
indem die Materialstreifen (11a bis 11d) mittels einer leicht zu lösenden Verbindung auf der Oberfläche des Trägerbauteils (1) fixiert werden,
in dem das Fixieren mittels eines Punktschweißverfahrens erfolgt.

2. Verfahren nach Anspruch 1,
in dem Materialstreifen (11a - 11d) auf eine Vielzahl von Oberflächenstellen des Trägerbauteils (1) aufgebracht werden.

3. Verfahren nach einem der vorangehenden Ansprüche,
in dem die Bauteile der Bauteilsorte aus einer Legierung hergestellt sind, welche ein Basismaterial als Hauptbestandteil aufweist und das Material des wenigstens einen Materialstreifen (11a bis 11d) ebenfalls das Basismaterial als Hauptbestandteil aufweist.

4. Verfahren nach Anspruch 3,
in dem die Legierung eine Superlegierung und das Basismaterial Eisen, Nickel oder Kobalt ist.

5. Verfahren nach einem der vorangehenden Ansprüche,
in dem die Bauteilsorte eine Sorte von Leit- oder Laufschaufeln für Gasturbinenanlagen ist.

6. Verfahren nach einem der der vorangehenden Ansprüche,
in dem nach dem Entfernen des Materialstreifens (11a bis 11d) ein Entfernen der Beschichtung von der Oberfläche des Trägerbauteils (1) erfolgt.

## Claims

1. Process for producing a coating sample for testing coating parameters of a coating that is to be applied to a specific type of component, comprising the steps of:
- applying at least one material strip (11a to 11d) to at least one specific surface location on a component (1) of the component type that is to be coated, which material strip forms a support component, the material of the material strip (11a to 11d) being selected in such a manner that the coating operation on the material strip (11a to 11d) corresponds to the coating operation carried out on the material from which the component (1) is produced, at least in terms of the coating parameters to be tested;
- coating the support component (1) having the at least one material strip applied to it;
- removing the material strip (11a to 11d) for use as a coating sample,
in which the material strips (11a to 11d) are fixed to the surface of the support component (1) by means of a connection which is easy to release,
in which the fixing is effected by means of a spot-welding process.

2. Process according to Claim 1,
in which material strips (11a - 11d) are applied to a multiplicity of surface locations on the support component (1).

3. Process according to one of the preceding claims,
in which the components of the component type are made from an alloy which comprises a base material as the main constituent, and the material of the at least one material strip (11a to 11d) likewise comprises the base material as the main constituent.

4. Process according to Claim 3,
in which the alloy is a super alloy and the base material is iron, nickel or cobalt.

5. Process according to one of the preceding claims,
in which the component type is a type of guide vane or rotor blade for gas turbine installations.

6. Process according to one of the preceding claims,
in which after the material strip (11a to 11d) has been removed, the coating is removed from the surface of the support component (1).

## Revendications

1. Procédé de production d'un échantillon de revêtement pour étudier des paramètres d'un revêtement à déposer sur une sorte déterminée d'élément, comprenant les stades dans lesquels :
- on dépose au moins une bande (11a à 11d) de matériau sur au moins un emplacement déterminé de la surface d'un élément de la sorte d'élément à revêtir, qui forme un élément de support, le matériau de la bande (11a à 11d) étant choisi de façon à ce que l'opération de revêtement sur la bande (11a à 11d) de matériau corresponde à celle du matériau en lequel l'élément (1) est produit, au moins en ce qui concerne les paramètres de revêtement à étudier ;
- on revêt l'élément (1) de support de la au moins une bande de matériau à y déposer ;
- on élimine la bande (11a à 11d) de matériau pour l'utilisation en tant qu'échantillon de revêtement,
en immobilisant les bandes (11a à 11d) de matériau à la surface de l'élément (1) de support au moyen d'une liaison facile à détacher,
en effectuant l'immobilisation au moyen d'un procédé de soudage par points.

2. Procédé suivant la revendication 1,
dans lequel on dépose des bandes (11a à 11d) de matériau sur une pluralité d'emplacements de surface de l'élément (1) de support.

3. Procédé suivant l'une quelconque des revendications précédentes,
dans lequel on produit les éléments de la sorte d'élément en un alliage qui a un matériau de base comme constituant principal et le matériau de la au moins une bande (11a à 11d) de matériau a également le matériau de base comme constituant principal.

4. Procédé suivant la revendication 3,
dans lequel l'alliage est un superalliage et le matériau de base est du fer, du nickel ou du cobalt.

5. Procédé suivant l'une quelconque des revendications précédentes,
dans lequel la sorte d'élément est une sorte d'aubes directrices ou d'aubes mobiles pour des installations de turbine à gaz.

6. Procédé suivant l'une quelconque des revendications précédentes,
dans lequel, après l'enlèvement de la bande (11a à 11d) de matériau, on effectue une élimination du revêtement de la surface de l'élément (1) de support.
